# FASCICULE DE BREVET EUROPEEN

(11) **EP 1 342 261 B1**
(45) Date de publication et mention de la délivrance du brevet: **04.03.2020**
(21) Numéro de dépôt: 01999968.9
(22) Date de dépôt: 05.12.2001
(51) Int. Cl.: H01L 21/363, H01L 31/0296, H01L 31/18

(54) **PROCÉDÉ DE RÉALISATION D'UN SEMICONDUCTEUR À LARGE BANDE INTERDITE DOPÉ POSITIVEMENT**
HERSTELLUNG EINES POSITIV DOTIERTEN HALBLEITERS MIT GROSSER BANDLÜCKE
METHOD FOR PRODUCING A POSITIVELY DOPED SEMICONDUCTOR WITH LARGE FORBIDDEN BAND

(30) Priorité: 07.12.2000 FR 0015900
(43) Date de publication de la demande: 10.09.2003
(73) Titulaire: Hosseini Teherani, Féréchteh, 91190 Gif sur Yvette (FR)
(72) Inventeur: Hosseini Teherani, Féréchteh, 91190 Gif sur Yvette (FR)
(86) Numéro de dépôt international: PCT/FR2001/003843
(87) Numéro de publication internationale: WO 2002/047147

(56) Documents cités:
- WO-A-00/08691
- SATO K ET AL: "Materials design for the low-resistivity p-type ZnO and transparent ferromagnet with transition metal atom doped ZnO: Prediction vs. experiment" MATERIALS SCIENCE OF NOVEL OXIDE-BASED ELECTRONICS;SAN FRANCISCO, CA, UNITED STATES APR 24-27 2000, vol. 623, 2000, pages 65-75, XP001020750 Mater Res Soc Symp Proc;Materials Research Society Symposium - Proceedings 2000
- MINEGISHI KAZUNORI ET AL: "Growth of p-type zinc oxide films by chemical vapor deposition" JPN J APPL PHYS PART 2 LETTER;JAPANESE JOURNAL OF APPLIED PHYSICS, PART 2: LETTERS NOV 1 1997 JJAP, TOKYO, JAPAN, vol. 36, no. 11A, 1 novembre 1997 (1997-11-01), pages L1453-L1455, XP002926102
- IWATA K ET AL: "Nitrogen-induced defects in ZnO:N grown on sapphire substrate by gas source MBE" JOURNAL OF CRYSTAL GROWTH, NORTH-HOLLAND PUBLISHING CO. AMSTERDAM, NL, vol. 209, no. 2-3, février 2000 (2000-02), pages 526-531, XP004186738 ISSN: 0022-0248
- YAMAMOTO T ET AL: "Unipolarity of ZnO with a wide-band gap and its solution using codoping method" JOURNAL OF CRYSTAL GROWTH, NORTH-HOLLAND PUBLISHING CO. AMSTERDAM, NL, vol. 214-215, juin 2000 (2000-06), pages 552-555, XP004201067 ISSN: 0022-0248

## Description

### Domaine technique

La présente invention a pour objet un procédé de réalisation d'un semiconducteur à large bande interdite dopé positivement selon la revendication 1.

Elle trouve une application dans la réalisation de semiconducteur en oxyde de zinc (ZnO) dopé positivement. L'invention permet de réaliser des composants semiconducteurs, comme des jonctions pn en ZnO.

### Etat de la technique

L'oxyde de zinc ZnO est aujourd'hui largement utilisé dans des dispositifs optoélectroniques. En raison de sa structure wurtzite, ZnO est naturellement un semiconducteur de type n en raison de son écart à la stoechiométrie. Les lacunes naturelles en oxygène (sites anioniques) conduisent à une redistribution de l'occupation des sites anioniques par des espèces cationiques, en l'occurrence Zn, s'insérant de manière interstitielle. Ces deux types de défauts conduisent à des niveaux donneurs situés à environ 0,05 eV de la bande de conduction.

On a déjà tenté de supprimer ces défauts pour obtenir du ZnO dopé positivement. Dans l'article de M. JOSEPH et al. intitulé "p-Type Electrical Conduction in ZnO Thin Films by Ga and N Codoping" publié dans la revue Jpn J. Appl. Phys., vol. 38 (1999), pp.

L 1205-L 1207, il est décrit un procédé consistant à effectuer un codopage avec Ga agissant comme donneur et N comme récepteur.

L'article de T. YAMAMOTO et al. intitulé "Solution Using a Cooping Method to Unipolarity for the Fabrication of p-type ZnO" publié dans la revue Jpn J. Appl. Phys., vol. 38 (1999), pp.. L 166-L 169, reprend cette méthode de codopage.

L'article de K. SATO et al. « Materials design for the low-resistivity p-type ZnO and transparant ferromagnet with transition metal atom doped ZnO : Prédiction vs. Experiment » publié dans la revue Material Science of novel oxide-based electronics ; San Francisco, CA, United States Apr 24-27 2000, vol. 623, 2000, pages 65-75, reprend également une technique de co-dopage où des éléments de In, Ga ou Al sont utilisés comme co-dopants avec de l'azote.

Et l'article de M. KAZUNORI et al. « Growth of p-type zinc oxyde films by chemical vapor déposition » publié dans la revue Jpn J. Appl. Phys Part 2 Letter; Japanese Journal of applied physics, part 2 décrit la croissance d'un film de ZnO de type p réalisé par addition de NH3 sur un porteur d'hydrogène et un excès de Zn dans la source de ZnO.

Le brevet US-A-4,904,618 propose un procédé pour doper des semiconducteurs à large bande interdite comme ZnSe ou ZnTe. Ce procédé consiste à incorporer au cristal un couple de dopants primaire et secondaire (par exemple, respectivement, N et Li), puis à supprimer le plus mobile des deux.

La difficulté de ces techniques tient dans le contrôle des mécanismes d'incorporation des constituants afin d'obtenir une composition chimique du front de croissance conduisant à une stoechiométrie appropriée du cristal épitaxié.

La présente invention a pour but de simplifier ces procédés connus.

### Exposé de l'invention

A cette fin, l'invention propose d'utiliser un seul élément (et non plus deux) ce qui simplifie notablement le contrôle du processus. L'élément utilisé doit agir en tant que surfactant à la surface de croissance du semi-conducteur pour inhiber la formation de lacunes (d'oxygène dans le cas de ZnO) par une couverture des sites anioniques actifs. Le résultat immédiat est l'absence d'écart stoechiométrique des espèces en surface, ce qui a pour effet d'éliminer le fort caractère n du semiconducteur.

Plus précisément, l'invention a pour objet un procédé de réalisation d'un semiconducteur à large bande interdite dopé positivement, selon la revendication 1.

Selon des modes de réalisation particuliers :
- le semiconducteur est de l'oxyde de zinc (ZnO),
- l'élément agissant comme surfactant comprend de l'arsenic,
- le dopant positif comprend de l'azote,
- le dopant positif comprend du magnésium.

L'invention s'applique à la réalisation de ZnO dopé p. Dans ce cas, l'élément unique agissant en tant que surfactant est de l'arsenic (As). Le dopage p peut être obtenu par un dopant classique comme Mg ou N. L'effet de ce dopant est renforcé de l'écart à la compension obtenue par la réduction du caractère négatif intrinsèque au matériau.

Le procédé de l'invention permet de stabiliser les matériaux à large bande interdite, notamment les matériaux à base de Zn. En effet, le composé ZnO croît naturellement sous forme n⁵, suite à la désorption de Zn pendant la phase de fabrication ou ultérieurement lorsqu'il est soumis à des traitements (par exemple thermiques). L'utilisation du procédé de l'invention permet de stabiliser le front de croissance et ainsi de limiter cette désorption, ce qui conduit soit à un matériau de type n doté d'une surface stable, soit un dopage de type p lorsqu'on associe ce procédé avec un dopage de type p. Le matériau ainsi obtenu peut alors être utilisé soit en couche tampon, soit en couche active de type n ou p.

Les structures à synthétiser peuvent être déposées sur des substrats divers, par exemple en ZnO ou sur un substrat recouvert d'une sous-couche à base de ZnO ou de Zn (couche tampon). Si ces sous-couches sont dopées n, alors, la structure finale conduira à une couche de type p, permettant ainsi l'obtention de diodes pn, ou de composants à base de diode pn.

Le problème du dopage dans les matériaux à large bande interdite doit être surmonté pour la fabrication de composants à base de jonctions p-n. En effet, le dopage intentionnel de type p requiert des niveaux d'énergie en bord de bande de valence (BV), tout en minimisant la compensation et l'activation des centres profonds. Ces états d'énergie localisés dans la bande interdite ne peuvent exister que par une distribution spatiale homogène des dopants pendant l'épitaxie, obtenue d'une manière générale lors d'un régime de croissance hors équilibre. C'est donc le processus de synthèse utilisé pendant l'épitaxie qui va contrôler le dopage.

### Exemples de mise en oeuvre du procédé

Pour mettre en oeuvre le procédé de l'invention, on peut utiliser une enceinte ultravide, afin de permettre un régime moléculaire des flux incidents (distance substrat source inférieure au libre parcours moyens des espèces utilisées). D'une manière générale, cette condition est obtenue dans les techniques appelées épitaxie par jets moléculaires, pulvérisation cathodique (magnétron ou non, R.F. ou D.C.), évaporation, ablation laser ou toute autre technique utilisant un système permettant d'atteindre un vide suffisant pour l'établissement du régime moléculaire (méthode de synthèse physique ou chimique).

Le substrat peut être en ZnO, Al₂O₃, GaN, Si, SiO₂, etc... Il est nettoyé suivant les techniques usuelles (traitement thermique sous vide ou sous oxygène, traitement chimique, etc...). Il est porté à une température optimale, qui est, pour Al₂O₃ de 200 à 800°C, pour le verre ou SiO₂ de 200 à 500°C, pour GaN de 600 à 800°C. La croissance de ZnO (avec ou sans autres éléments) est obtenue soit par un apport d'atomes de Zn (par MBE, évaporation, pulvérisation, ablation ou CVD en présence d'oxygène). Pour limiter la désorption de Zn, cette croissance s'effectue en présence d'un flux d'In ou d'As ou de Mg, obtenu grâce à une source physique ou chimique. Ce flux est maintenu tout au long de la croissance. Ainsi, pour obtenir du ZnO dopé de type n, la croissance s'effectue de la manière usuelle, mais sous un flux permanent d'In (ou d'As ou de Mg). Pour obtenir du ZnO dopé p par codopage, la croissance s'effectue en présence d'un flux de N ou de Ga, avec un flux constant d' As pour stabiliser le front de croissance.

La croissance doit être hors équilibre, condition conduisant à la maîtrise des mécanismes d'incorporation via non pas des équilibres thermodynamiques mais le contrôle des cinétiques d'incorporation propres à chacun des éléments sur la surface de croissance.

Les états d'équilibre entre les différents constituants du front de croissance déterminent une stoechiométrie de surface différente de celle du cristal. Par le choix adéquat des conditions de croissance, ces différents états d'énergies de surface sont paramétrés par des mesures extrinsèques au cristal. Ainsi, à chaque élément correspond des critères spécifiques tels que le flux, la tension de vapeur, ou encore le coefficient de collage sur le substrat.

Dans le cas de composés à composition majoritaire de ZnO, la désorption des atomes de Zn à la surface de croissance dépend de l'équilibre de l'énergie cinétique fournie et des énergies d'interaction verticale et horizontale à l'origine du confinement des atomes de Zn vers la surface. Les énergies d'interaction dépendent de la composition de l'alliage et, de ce fait, les informations concernant la composition de surface de l'alliage sont déduites selon le comportement des atomes de Zn lors de la désorption. L'occupation des sites de surface est alors contrôlée par une caractérisation croisée intrinsèque (telle que la diffraction d'électrons à haute énergie appelée RHEED) et extrinsèque (telle que la microscopie à force atomique appelée AFM, ou une analyse des propriétés électriques, etc...).

## Revendications

1. Procédé de réalisation d'un semiconducteur à large bande interdite dopé positivement, dans lequel on fait croître le semiconducteur en présence d'un seul élément agissant comme surfactant à la surface de croissance pour inhiber la formation de lacunes, dans lequel on dope le semiconducteur avec un dopant positif approprié, le semiconducteur étant de l'oxyde de zinc (ZnO), **caractérisé en ce que** l'élément agissant comme surfactant est de l'arsenic (As).

2. Procédé selon la revendication 1 dans lequel le dopant positif est de l'azote.

3. Procédé selon la revendication 1 dans lequel le dopant positif est du magnésium.

## Patentansprüche

1. Verfahren zur Herstellung eines positiv dotierten Halbleiters mit breiter Bandlücke, wobei der Halbleiter in Gegenwart eines einzelnen Elements gezüchtet wird, das als Tensid auf der Wachstumsoberfläche wirkt, um die Bildung von Leerstellen zu verhindern, wobei der Halbleiter mit dotiert wird ein geeigneter positiver Dotierstoff, wobei der Halbleiter Zinkoxid (ZnO) ist, **dadurch gekennzeichnet, dass** das als Tensid wirkende Element Arsen (As) ist.

2. Verfahren nach Anspruch 1, wobei der positive Dotierstoff Stickstoff ist.

3. Verfahren nach Anspruch 1, wobei der positive Dotierstoff Magnesium ist.

## Claims

1. A method for producing a positively doped wide bandgap semiconductor, wherein the semiconductor is grown in the presence of a single element acting as a surfactant on the growth surface to inhibit the formation of vacancies, wherein the semiconductor is doped with a suitable positive doping, the semiconductor being zinc oxide (ZnO), **characterized in that** the element acting as surfactant is arsenic (As).

2. The method of claim 1 wherein the positive dopant is nitrogen.

3. The method of claim 1 wherein the positive dopant is magnesium.
